# EUROPEAN PATENT SPECIFICATION

(11) **EP 1 790 755 B1**
(45) Date of publication and mention of the grant of the patent: **12.12.2012**
(21) Application number: 06122186.7
(22) Date of filing: 12.10.2006
(51) Int. Cl.: C23C 14/24, G21K 4/00

(54) **Method of vaporisation of phosphor precursor raw materials.**
Verfahren zur Verdampfung von Rohstoffen eines Leuchtstoffvorprodukts
Procédé de vaporisation de matières premières de précurseurs phosphorescents

(30) Priority: 28.10.2005 EP 05110122
(43) Date of publication of application: 30.05.2007
(73) Proprietor: Agfa HealthCare NV, 2640 Mortsel (BE)
(72) Inventor: Tahon, Jean-Pierre, 2640, Mortsel (BE); Verreycken, Guido, 2640, Mortsel (BE); Leblans, Paul, 2640, Mortsel (BE)
(74) Representative: Theunis, Patrick

(56) References cited:
- US-A1- 2003 221 618
- US-A1- 2005 000 448
- US-A1- 2005 103 273

## Description

### FIELD OF THE INVENTION

The present invention relates to a method of preparing a storage phosphor plate by a vapour deposition process. More particularly the invention is related to vapour deposition from a dedicated crucible unit in order to optimise the speed of said phosphor plate.

### BACKGROUND OF THE INVENTION

In a vapour deposition process, performed in a vapour deposition apparatus, following configurations in said apparatus are known from the prior art.

As described in WO 90/12485 an apparatus for use in a physical vapour deposition process comprises at least two evaporators with means in order to maintain each evaporator at an independent temperature, a temperature controlled collector, a vessel which embraces or communicates with the evaporators said vessel defining therewithin a vapour mixing chamber having a discharge opening facing the deposition support, and means in order to maintain the vessel walls in the part thereof, delimiting the vapour mixing chamber at a temperature at least as high as the hotter or hottest evaporator thereby in order to enhance mixing of the respective vapour streams, whilst suppressing condensation of vapour on the chamber walls: evaporators are located at differing levels versus the position of the deposition support, so that the evaporator containing the less volatile component is at a level between the other evaporator with the most volatile component and the deposition support, i.e., more close to the chimney walls and chimney slot outlet (3').

Another configuration is described in WO 92/07103 and US-A 5,348,703 as a centrally positioned crucible with the less volatile component, wherein said less volatile component is electron beam radiated in order to become vaporised; wherein said centrally positioned crucible is surrounded by crucibles filled with the more volatile component and heated by means of radiant heaters and wherein vapour streams of the more volatile component are lead through nozzles into the vapour stream of the electron beam vaporised less volatile component in order to become deposited together onto a support.

In the more recently issued US-A 6,875,990 a method for preparing a radiation image storage panel has been described, said method comprising the preparation of on a substrate of a phosphor layer of a stimulable CsBr:Eu phosphor, said method comprising vaporising one or more vaporisation sources comprising a mother component and one or more vaporisation sources comprising a europium element such that the vaporisation of the mother component sources is controlled independent on the vaporisation of the europium element sources, in order to form a storage phosphor layer on a substrate providing thereby a photostimulable phosphor screen or panel, suitable for use in computed radiography.

A vapour deposition apparatus, developed in particular for on-line deposition of such a phosphor or, alternatively, a scintillator material as described in US-A 2005/0000448, comprises a crucible containing a mixture of raw materials, a chimney having at least one outlet in communication with the said crucible and a linear slot outlet, one or more lineair heating elements, contained within said chimney, an oven surrounding said crucible, wherein said oven contains heating elements, shielding elements and cooling elements.

Even more recently in US-Application 2005/0160979 a film deposition system for depositing a polycrystalline film on a large area substrate has been disclosed. The system includes a chamber formed of a set of walls, the set of walls defining at least three temperature zones within the chamber. Each of the walls is thermally insulated from the other walls forming the chamber. The system further includes a vacuum source, a set of heat sources, and a plurality of temperature detectors for detecting the temperature of the walls in the set of walls. Temperature control modules monitor and control the temperature in each of the temperature zones. The temperature control modules maintain predetermined temperatures in the walls so that the total mass of film-forming material lost through parasitic losses is less than the film mass deposited on the large area substrate. A method for depositing a polycrystalline film is also described. In yet other embodiments of the method, the step of forming includes forming a first, a second and a third temperature zone where the temperatures of the walls are maintained at predetermined temperatures T1, T2, and T3 respectively, the second temperature zone being the zone wherein the rate of condensation of the vapour of the film-forming material is greater than the rate of the evaporation of the material; and the step of providing and positioning further includes the steps of:
- positioning the film-forming material in the first temperature zone where its temperature is controlled at the first predetermined temperature T1 so that a phase change may occur and the material may be evaporated;
- positioning the substrate in the second temperature zone where its temperature is controlled at the second predetermined temperature T2, T2 being the temperature wherein the rate of condensation exceeds the rate of evaporation of the film-forming material, and wherein
- the third temperature zone is situated between the substrate and the film-forming material wherein the third predetermined temperature T3 is controlled to allow the evaporated film-forming material to remain substantially as a vapour as it moves through the chamber toward the substrate for deposition thereon substantially without parasitic deposition in other parts of the chamber.

The relationship between T1, T2 and T3 can be such that either T1 ≥ T3 > T2, or T1 > T2 and T1 ≤ T3 >T2.

In EP-A 1 460 642 application of the method to coat a surface as large as possible in a way to get a homogeneous deposit of phosphor or scintillator material over quite a large screen, sheet, plate or panel surface area has become available. Said method not only allows quite a lot of configurations in the vapour deposition coating apparatus as set forth therein, but moreover, by making use of a moving flexible substrate, supplied in roller form, huge areas deposited with a phosphor layer, are available. Out of these layers the right formats as desired can be cut and laminated against a rigid substrate.

In US-A 7,070,658 further information has been given with respect to particular parts in the vapour deposition unit, in order to reach the object of further improving homogeneity of vapour deposition, more in particular with respect to the heating systems. Measures in order to maintain the temperature within the crucibles at a level so that condensation of scintillator or phosphor material onto the walls of the chimney is avoided, comprise presence of a heat shield with a slit in order to let the vapours pass. Preferably said radiation heaters are quartz halogen heaters, present in order to heat the chimney and in order to overcome condensation of vaporized materials. So in the Examples a crucible in form of an elongated boat having a length of 1 m and a width of 4 cm composed of "tantalum" with a thickness of 0.5 mm has been demonstrated with 3 integrated parts: a crucible container, an internally heated chimney and a controllable outlet. The chimney therein is provided with 3 linear radiation heaters with a diameter of 11 mm, emitting moreover, besides infrared radiation, radiation of shorter wavelengths. Preferably said radiation heaters are quartz halogen heaters, present in order to heat the chimney and in order to overcome condensation of vaporised materials. Moreover the chimney heaters have been positioned in a baffled way in order to overcome spatter of molten or vaporised material onto the substrate into an uncontrolled and unlimited way. A lip opening of 5 mm as controllable outlet has been used. A heat shield with slit opening is further shielding heat in order to avoid escape of heat and loss of energy, required to provoke vapour escape and deposit onto the continuously moving substrate support in a controlled and uniform way. Under vacuum pressure (a pressure of 2 x 10⁻¹ Pa equivalent with 2 x 10⁻³ mbar) maintained by a continuous inlet of an inert gas like argon or nitrogen into the vacuum chamber (1), not excluding use of dry air, and at a sufficiently high temperature of the vapour source (760°C) and the chimney, the obtained vapour has been directed towards the moving sheet support and has been deposited thereupon successively while said support has been moving along the vapour stream. Said temperature of the vapour source has been measured by means of thermocouples present outside and pressed under the bottom of said crucible and tantalum protected thermo-couples present in the crucible and in the chimney.

Apart from some particular crucible configurations with a convection member and an indication about a substrate temperature of about 120°C, preferably at least 160°C for a substrate in a continuous vaporisation apparatus, wherein a substrate is radiation heated up to such a substrate temperature, no indication can be found about crucible temperatures in US-A 2005/0103273.

So in EP-A 1 568 751 no specifically detailed information has further been given with respect to temperatures in the crucibles either: apart for providing a method for producing a binderless phosphor screen or panel by the steps of depositing a CsX:Eu phosphor on a substrate, within a temperature T from Tmelt-100 °C to Tmelt+100 °C, wherein melting temperature Tmelt represents the melting temperature of the desired phosphor, no indication or detail has been given about temperatures or desired temperature changes within the crucibles. In this reference an improvement for resistance to moisture of the produced CsBr:Eu screens or panels has been given by making use of selected stable CsₓEuyX'_{x+αy} complexes as starting components for performing the vapour deposition process.

None of these references however specifically relates to particularly suitable temperatures or temperature differences within the crucible configuration that moreover provide means to further improve phosphor stability with respect to moisture sensitivity, thus making decrease storage phosphor screen speed to a lesser extent, i.e. to maintain high screen speed in a better way than ever been made possible hitherto.

### SUMMARY OF THE INVENTION

The above-mentioned advantageous effects have been realised by a method having the specific features as set out in claim 1.
Specific features for preferred embodiments of the invention are set out in the dependent claims.
Further advantages and embodiments of the present invention will become apparent from the following description and drawings.

### BRIEF DESCRIPTION OF THE DRAWINGS

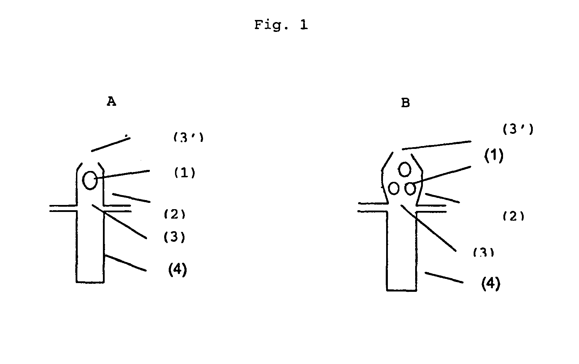

Fig. 1 shows chimney heaters (1), an internally heated chimney (2), a chimney inlet (3) and outlet (3') and a crucible, tray or boat (4), wherein in configuration A only one lamp is present as a longitudinal heating element, and wherein in configuration B three lamps are present as a longitudinal heating elements, arranged in order to act as baffles, thereby avoiding spatter from the crucible unit onto a support material for the phosphor layer to be vapour deposited.

### DETAILED DESCRIPTION OF THE INVENTION

It is known that an expansion of vapour when escaping over a narrow slit provokes that vapour is cooled. As a consequence there is a danger that condensation onto the narrow slit occurs and that spatter and inhomogeneous deposition leads to production of unevenness, spots onto the phosphor plate and less sensitive and unstable plates.
A solution has been found now by applying a method of preparing a storage phosphor layer on a support by vapour deposition from a crucible unit by the steps of heating as phosphor precursor raw materials a matrix component and an activator component or a precursor component thereof, optionally mixed with said matrix, said activator compound or a mixture thereof, wherein said crucible unit comprises at least a bottom and surrounding side walls as a crucible for phosphor precursor raw materials present in said crucible in liquid form, wherein said crucible unit further comprises at least a chimney as part of the crucible unit and a slit allowing phosphor precursor raw materials to escape in vaporised form from said crucible unit in order to become deposited as a phosphor layer onto said support, wherein the step of heating said precursor raw materials in the crucible in liquid form proceeds up to a temperature T1 and the step of heating said precursor raw materials in vaporised form in said chimney, proceeds up to a temperature T2, characterised in that a positive difference in temperature [T2 - T1] is maintained. The expression "is maintained" expresses that such a temperature difference is left about unchanged, i.e. constant within a temperature deviation of at most about 5°C and even less.

Additional heating - in form of pre-heating before starting vaporization or while performing vaporization - proceeds by means of resistive heating, radiation heating or a combination thereof - i.e. by lamps as e.g. quartz lamps or infrared lamps, preference given to quartz halogen lamps.

With respect to additional heaters for the substrate, resistive heaters as well as radiation heaters may be applied. Resistive heaters are defined herein as providing invisible infrared radiation, i.e. radiation in the longer wavelength range above 700 nm, whereas radiation heaters in form of lamps are emitting, besides infrared radiation in the longer wavelength range above 700 nm, also visible radiation in the spectral wavelength range below 700 nm.

In the method according to the present invention, said temperatures T1 and T2 are attained by radiation heating, resistive heating or a combination of radiation heating and resistive heating. In a particular embodiment in the method of the present invention said temperatures T1 and T2 are thus attained by radiation heaters emitting radiation having wavelengths below 700 nm besides infrared radiation, wherein quartz halogen lamps are recommended, besides (electrical) resistive heating. Whereas the crucible container is normally heated by resistive heating, the chimney temperature is advantageously enhanced by the said radiation heaters, without however being limited thereto.

A solution is thus offered by providing an amount of additional energy, e.g. by installing or mounting one or more heater(s) (as e.g. in form of lamps) in the chimney in order to stear, to control and to maintain the local temperature therein. Moreover positioning said heaters in form of lamps, as e.g. halogen quartz lamps as set forth hereinbefore, making them effectively act as baffles in order to prevent spatter onto the deposited phosphor layer, is highly recommended, in order to ensure homogeneous vaporisation over the whole narrow slit as a part of the chimney making part of the crucible unit, and in order to avoid deposition of undesired spots onto the screen plate or panel.

In order to avoid spatter, such an arrangement is even more preferred than an assembly for vaporising raw materials in order to prepare vapour deposited phosphor materials as described in US-A 2005/0000411. Therein a crucible has been provided with two plates or covers, wherein one thereof is an outermost plate or cover provided with a perforation pattern, selected from the group consisting of one or more slits, in series or in parallel, and of openings having the same or different diameter, randomly or regularly distributed over said cover, moreover covering said crucible having a bottom and surrounding side walls with a height "h", wherein that second plate is mounted internally in the crucible at a distance from said outermost cover plate of less than 2/3 of side wall height "h".

It is further confirmed that such an arrangement is also more preferred than an assembly for vaporising raw materials in order to prepare vapour deposited phosphor materials as described in US-A 2005/0217567. Therein an assembly comprising two plates or covers has been described: one being an outermost plate or cover, and both, at least in part having a perforation pattern over a surface area covering an open side of a crucible having a bottom and surrounding side walls containing raw materials, wherein said outermost cover is mounted at a distance farther from the said crucible than said cover covering the open side of a crucible, and wherein both covers are mounted versus each other, so that, when viewed through an axis in a direction perpendicular to the bottom of the crucible from a distance to said outermost cover of at least 10 times the distance between said two plates or covers, its contents cannot be observed.

An attempt to obtain a sufficiently well distributed heat pattern over the crucible units having a bottom and surrounding side walls has been described in US-A 2005/0000447 and can advantageously be applied in the present invention, further taking into account the measures described in detail in the present invention. Provided with electrode clamps at exterior sites of side walls located opposite with respect to each other, said sites are extending as lips at said side walls, and said clamps are connectable with electrodes for resistively heating said crucible, improved in that a cross-section of each of said lips between between crucible wall and clamp is reduced with at least 5% as described therein.

At the other side, another problem may occur by adding that extra energy to the vapour escaping from the crucible unit, in that the substrate whereupon the vapour should be deposited, is heated. This problem however is more related in smaller units than in a vapour depositing apparatus having a larger volume, such as an apparatus for continuous on-line vaporisation, wherein a substrate, attached to one or more rollers is continuously moving along the slit opening of the crucible unit as in US-A's 2004/0219289 and 2004/0224084 .

As a solution for that problem a small vapour depositing apparatus a cooling unit may be provided with a cooling unit, mounted in the vicinity of the crucible unit, outside the crucible, so that the substrate temperature is controlled, and, more preferably, steered along a back-coupling mechanism.

In another embodiment the said cooling unit may be mounted at the side of the substrate where no vapour deposition occurs (as e.g. is the case in a batch process) or inside the roller whereupon the substrate has been mounted, which may become cooled internally as e.g. in a continuous process as described e.g. in US-A 2004/0224084 and in EP-A 1 460 642. In case of the batch process said substrate is rotating around an axis parallel with or inclined at a well-defined angle versus the vapour stream escaping from the crucible unit(s) present in the batch vapour deposition apparatus. Alternatively the substrate or support may be at a fixed position, whereas the crucible unit(s) may be rotated around a virtual axis parallel with or inclined at a well-defined angle versus an axis perpendicular to said support or substrate. Further details about batch vapour deposition processes can be found in US-A 6,802,991.

Measuring or steering circuits are advantageously coupled in order to keep the substrate temperature constant within deviations thereupon not exceeding 5°C, more preferably not more than 2°C, and still more preferably even not more than 1°C.

According to the present invention a method of preparing a storage phosphor layer on a support is provided, said method being performed by vapour deposition from a crucible unit and/or by heating as phosphor precursor raw materials a matrix component and an activator component or a precursor component thereof, as, e.g., CsBr, EuBr₂, EuBr₃ or CsBr mixed with EuBr₂, EuBr₃ or a mixture of EuBr₂ and EuBr₃, wherein said crucible unit comprises at least a bottom and surrounding side walls as a crucible for phosphor precursor raw materials present in said crucible in liquid form, and wherein said crucible unit further comprises at least a chimney as part of the crucible unit and a slit allowing phosphor precursor raw materials to escape in vaporised form from said crucible unit and to deposit it as a phosphor layer onto said support, wherein the step of heating said precursor raw materials in the crucible in liquid form proceeds up to a temperature T1 and wherein the step of heating said precursor raw materials in vaporised form in said chimney, proceeds up to a temperature T2, characterised in that a positive difference in temperature [T2 - T1] is effectively maintained.

According to the method of the present invention said temperatures are controlled by means of thermo-couples.

More particularly according to the method of the present invention, said temperatures are controlled and steered by means of thermo-couples.

Preferably, according to the method of the present invention, said temperatures are steered by means of thermo-couples via a back-coupling mechanism.

Further according to the method of the present invention a set of coupled thermo-couples is mounted in the raw materials, covering part of the bottom of the said crucible.

It is particularly preferred that according to the method of the present invention a set of coupled thermo-couples is present at the outside of the crucible in contact with the bottom of said crucible in order to measure and steer temperature T1.

Moreover it is particularly preferred that according to the method of the present invention a set of coupled thermo-couples is present in the vaporised raw materials in the said chimney in order to measure and steer temperature T2. More particularly, in an apparatus for continuous on-line vapour deposition over a total length of e.g. 1 m, it is recommended to determine and steer the temperature profile over the said total length. A set of bundled thermo-couples, different in length in order to measure the temperature at different sites over the said total length, are arranged in a tube, such as a quartz tube. More preferably, differences in length are constant in order to measure over constant length intervals, e.g. at positions differing 10 cm each. In order to work still more accurately, the temperatures at positions differing 5 cm each may be measured.

In one embodiment of the method according to the present invention CsX is a matrix component and EuX₂, EuX₃, EuOX or a mixture thereof are activator components, X representing Cl, Br, I or a combination thereof.

In another embodiment of the method according to the present invention CsₓEuyX'_{(x+αy)} is an activator precursor material, wherein x, y and α are integers, wherein x/y is more than 0.25 and wherein α is at least 2 and wherein X' represents Cl, Br, I or a combination thereof.

As a desired result the method according to the present invention provides a storage phosphor, wherein said storage phosphor is CsBr:Eu. Said CsBr:Eu storage phospher is coated in a binderless layer after having been vapour deposited according to the method of the present invention.

According to the method of the present invention, temperature T1 is higher than 640°C, preferably at least 680°C, when preparing the desired CsBr:Eu phosphor.

Further according to the method of the present invention, temperature T2 is higher than 640°C.

In such practical vapour depositions in order to prepare such a CsBr:Eu phosphor, T1 should e.g. at least be 710°C; in an even more preferred embodiment at least 720°C, wherein temperatures higher than 750°C are not excluded. Accordingly T2 should be at least be higher than 750°C, more preferably in the range from 800°C to 850°C, and even up to 950°C.

In a more particular embodiment in the method according to the present invention a difference in temperature [T2 - T1] of at least 80°C is maintained. Even a temperature difference up to 130°C-150°C, i.e. a range of 50°C-70°C in excess, should be maintained.

In one embodiment of the method according to the present invention, said vapour deposition proceeds in a batch process.

In another embodiment of the method according to the present invention, said vapour deposition proceeds in a continuous process.

As an advantageous effect of the present invention it has unexpectedly been found that for the same coating amount of phosphor in a vaporisation process, modified according to the present invention, an enhanced phosphor speed is measured for a process, wherein both the more and the less volatile raw material components or precursors are evaporated from one and the same crucible unit.

The vapour deposition apparatus used for performing the method according to the present invention, further has, in a preferred embodiment, three chimney heating elements (chimney heaters) mounted versus said slot outlet (3'), and positioned so that there is no direct path for vaporised particles from said raw materials to escape through said slot outlet (3'). Such an arrangement is more particularly required in order to avoid spattering and the chimney heaters are acting as baffles. In another embodiment a refractory plate, e.g. a tantalum plate, is mounted internally in the crucible under the baffling chimney heaters. Said crucible and said plate is further mounted between an electrode pair, in order to provide further homogeneous heating over the whole heat-conducting assembly, in favour of homogeneous deposition of phosphor or scintillator material. In the vapour deposition apparatus according to the present invention said (controllable) slot outlet (3') is a rectangular slot outlet.

It is a particular advantage that in the vapour deposition apparatus suitable for performing the method according to the present invention, said chimney heating elements (1) are movable in an upward or downward position.

In the case of a continuous process wherein the vapour deposition apparatus provides ability for one carrier roller to rotate around its axis by means of a motor, whereas the other one or more rollers are rotating by movement of said one roller in a controlled way, the position of the flexible substrate while rotating on the rollers is controlled by means of an optical positioning sensor, coupled back to pressure regulating cylinder(s), thus providing position adjustment of said flexible substrate.

A substrate or support material whereupon the scintillator or phosphor material is deposited in the vapor depositing apparatus used in the method according to the present invention, is composed of glass, a ceramic material, a polymeric material or a metal; more preferably a material selected from the group consisting of glass, polyethylene therephthalate, polyethylene naphthalate, polycarbonate, polyimide, carbon fibre-reinforced plastic sheets, aluminum, Pyrex^{®}, polymethylacrylate, polymethylmethacrylate, sapphire, zinc selenide, Zerodur^{®}, a ceramic layer and a metal or an alloy selected from the group of aluminum, steel, brass, titanium and copper. It should even not be limited thereto as in principle, any metal or synthetic material resisting irreversible deformation, e.g. as by melting, after addition of energy to the extent as commonly applied in the coating process of the present invention, is suitable for use. Particularly preferred as flexible substrate in method of the present invention is aluminum as a very good heat conducting material allowing a perfect homogeneous temperature over the whole substrate. As particularly useful aluminum substrates, without however being limited thereto, brightened anodised aluminium, anodised aluminium with an aluminium mirror and an oxide package and, optionally, a parylene layer; and anodised aluminium with a silver mirrror and an oxide package and, optionally, a parylene layer; available from ALANOD, Germany, are recommended. So as a preferred flexible substrate support an anodized aluminum support layer, covered with a protective foil, is recommended. Such an anodized aluminum support layer may have a thickness in the range of from 50 µm to 500 µm, and more preferably in the range from 200 µm to 300 µm. Such an anodized aluminum substrate has shown to be particularly favourable indeed with respect to adhesion characteristics with respect to vapour deposited phosphors or scintillators and even bending of that flexible aluminum support coated with a scintillator layer having a thickness of 500 µm up to 1000 µm, does not cause "cracks" or delamination of scintillator or phosphor "flakes". No problems have indeed been encountered with respect to occurrence of undesirable cracks when prepared in the vapour deposition apparatus of the present invention.

While vapour deposition proceeds the temperature of the said flexible substrate is maintained in the range from 150°C to 300°C, more preferably in the range from 150°C to 250°C and still more preferably in the range from 180°C to 220°C, envisaging a target temperature of about 200°C, by means of regulable radiation heaters. An adressable cooling unit may be installed along the support. More particularly, in favour of a homogeneous coating profile on the roller substrate in a continuous vapour deposition process, use is made of halogen quartz lamps providing a better heat absorption by aluminum, wherein said halogen quartz lamps are arranged parallel versus the rotating support. It is advantageous to arrange said individual quartz lamps in a horizontally arranged array consisting of two rows, each of which form overlapping lamp positions, not covered by the neighbouring array. Arranging e.g. 13 quartz lamps over the total width of the support to be coated continuously by vapour deposition in that way, provides ability to perform support temperature profile measurements at, e.g. 5 positions over the coated support, wherein inbetween each position the temperature profile is interpolated. Based on those measurements and interpolated calculations, the heating quartz lamps are steered via a back-coupling mechanism: an individual temperature profile, steering the temperature of the continuously passing substrate support by a heating/non-heating back-coupling mechanism thereby homogenises the coating thickness profile in the width direction of the web support to be coated. A reflecting, e.g. parabolic, screen as e.g. a tantalum screen, may advantageously be present behind each lamp of both lamp arrays. As it is important to keep the total heat within the vapour depositing system in order to provide high enough a constant substrate temperature, and as heat losses more probably appear in the vicinity of the support borders, i.e. far from the center of the roller supported support, supplementary quartz lamps are installed in that vicinity in order to compensate for the said heat losses.

Therefore it is recommended to provide a double-faced crucible unit in order to get an isolated crucible and chimney, wherein loss of energy is minimised. Apart from those measures related with homogeneity of thickness of deposited layers, steered variations of the slit opening over the length (in the width direction) of the crucible unit may additionally be useful. Over the whole length of the slit opening titanium blocks are advantageously arranged therefor, wherein addition of energy by resistive heating for each block apart allows expansion of said block in order to make decrease the slit opening by reversibly pressing at particularly required sites. Such a variation is preferably applied by steering the system as a consequence of thickness profile unevenness measurements over the whole width of the support, mounted on a roller in a continuous vaporisation system. Means in order to control layer thickness and layer thickness profiles of deposited material are advantageously installed to steer the said thickness and in order to control and stop the deposition process when the desired thickness is attained. So in the vapour deposition zone a thickness measuring system, based on capacitance measurements, is installed, thereby determining thickness while vapour depositing said scintillator or phosphor layer. In another embodiment use may be made of a radioactive source, as e.g. a gamma-ray source, providing thickness measurements, based on radiation absorption measurements in that case.

In such vapour depositing apparatus suitable for use for continuous vapour deposition as explained hereinbefore, the method according to the present invention may further make use of a cooling unit, build up of a black body cooling element, cooled with water at room temperature on the backside, and of an addressable (opened or closed) screen of louvers in form of multiple slats on the front or support side of said cooling element. Temperature measurements and registrations of the temperature profile of said flexible substrate may advantageously be used as input for steering substrate heating and/or substrate cooling devices. So in a vapour depositing apparatus temperatures are advantageously measured at the most critical points by means of a set of pyrometers. In one embodiment said pyrometers are lens based pyrometers with a parabolic reflector on top. In a preferred embodiment thereof said reflector is a gold evaporated mirror, wherein each focus of the said parabolic reflector is arranged in order to coincide with each focus of the corresponding pyrometer lens.

It is evident that the composition of the raw material in the container(s) (crucible(s)) of the vapour depositing apparatus used in the method according to the present invention is chosen in order to provide an end composition or coating composition as desired, wherein said composition is determined by the ratios of raw materials present. Ratios of raw materials are chosen in order to provide the desired chemical phosphor or scintillator composition after deposition of the vaporised raw materials. It is desirable to mix the raw materials in order to get a homogeneous raw mix in the crucible(s) in form of solid powders, grains or granules, or as pastilles having a composition corresponding with the desired ratios of raw materials in order to provide the desired phosphor coated onto the moving substrate material. A milling procedure, whether performed before, outside or inside the vapour deposition apparatus, may be favorable in order to provide a high degree of homogeneity before vaporisation and is therefore recommended. In case of milling inside the vapour depositing apparatus, said milling step may be performed inside or outside the crucible unit or units. Differing components may also be vaporised from different crucibles, arranged in series or in parallel or in a combined arrangement as already suggested hereinbefore, provided that a homogeneous vapour cloud is presented to the flexible substrate via the vapour stream or flow, deposited by condensation onto said substrate. Two elongated one-part boats having same or different raw material content or raw material mixtures may e.g. be present in series in the moving direction of the web. In another embodiment, if providing a more homogeneous coating profile, boats may be arranged in parallel on one axis or more axes, perpendicular to the moving direction of the support, provided that overlapping evaporation clouds again are providing a vapour stream that becomes deposited onto the support in a phosphor or scintillator layer having a homogeneous thickness, composition and coated amount of said phosphor or scintillator. Presence of more than one crucible may be in favour of ability to supply greater amounts of phosphor or scintillator material to be deposited per time unit, the more when the flexible substrate should pass the vapour flow at a rate, high enough in order to avoid too high temperature increase of the substrate. The velocity or rate at which the substrate passes the container(s) should indeed not be too slow in view of undesired local heating of the substrate support, making deposition impossible, unless sufficient cooling means are present in favour of condensation. The supporting or supported substrate should therefore preferably have a temperature maintained between 120°C and 300°C, preferably between 150°C and 250°C in order to obtain deposited phosphor or scintillator layers having the desired optimized properties.

It is clear that energy should be supplied to one or more container(s), also known as crucible(s), tray(s) or boat(s), in order to provoke a vapour flow (or stream) of the raw materials present therein, which become vaporised in the sealed vacuum zone: energy is submitted thereto by thermal, electric, or electromagnetic energy sources. As an example of an electromagnetic energy source a diode, a cathode arc, a laser beam, an electron beam, an ion beam, magnetron radiation or radio frequencies may be used, whether or not pulsed, without however being limited thereto. Electric energy is commonly provided by resistive heating, making use of resistance coils wound is around the container(s) or crucible(s) in a configuration in order to get conversion into thermal energy, thereby providing heat transfer to the containers or crucibles filled with the raw materials that should be evaporated. Energy supply to an extent in order to heat the container(s) or crucible(s) up to a temperature in the range from 550°-900°C is highly desired. At those temperatures, it is clear that containers should resist corrosion, so that refractory containers are preferred. Preferred container or crucible materials are tungsten, tantalum, molybdenum and other suitable refractory metals. Energy supply as set forth heats the mixture of raw materials in the crucible to a temperature above 450°C, preferably above 550°C, and even more preferably in the range of 550°C up to 900°C, e.g. at about 700°C.

Once the raw materials in the crucible are in a liquid state by the heating process, mainly obtained at that stage by resistive heating, a cloud of vaporised material, originating from the target raw materials escapes in form of a flow or stream from the container(s) or crucible(s) in the direction of the moving substrate in case of continuous vapour deposition, where a coated layer is formed by condensation. Most critical is the moment when all of the raw materials in the crucible become liquefied as the probability that spattered raw material is erupting through the slit opening of said crucible onto the support is high. In order to avoid such an undesired deposit of spatter in form of particle drops onto the support, the crucible is drawn away from its center position in the vapour depositing apparatus and directed outside the zone where continuous deposition onto the support occurs. As soon as a continuous vapour stream appears, free from the said undesired deposit of spatter, the crucible unit is installed in the centre of the apparatus again, within the "window" or "vapour deposition zone", allowing undisturbed deposition onto the support material.

From the description above it is clear that, in order to obtain a homogeneous coating profile as envisaged, a homogeneous cloud can only be realised when homogeneity is provided in the bulk of the liquefied raw material, i.e., after some critical time during which a transition from a mixed solid-liquid phase to a liquid phase appears. As a consequence, a homogeneous distribution of energy supplied over the container is a stringent demand. In a preferred embodiment, in favour of homogeneity, the crucible is in form of a single elongated "boat" with a largest dimension corresponding with the width of the flexible support moving over the said crucible so that at each point of its surface area the momentarily velocity magnitude is constant. If required during or after the deposition process oxygen may be introduced into the vacuum deposition chamber via a gas inlet, in form of oxygen gas. More particularly an annealing step, performed between two deposition steps or at the end of the phosphor deposition may be beneficial. An important factor with respect to the coating profile obtainable on the substrate support in the vapour depositing apparatus of the present invention, is the distance between container(s) and moving substrate as the said distance determines the profile of the vapour cloud at the position of the flexible substrate. Average values of shortest distances between crucible(s) and substrate are preferably in the range of from 5 to 10 cm in the continuous process in a large volume vapour deposition apparatus, and said average distances may even be from 10 to 20 cm, more preferably about 15 cm in the batch process, when performed in a smaller volume deposition apparatus. Too large distances would lead to loss of material and decreased yield of the process, whereas too small distances would lead to too high a temperature of the substrate, more particularly in the case of a smaller vapor deposition chambers in a vapor deposition apparatus, used in a batch process. Also in the batch process care should be taken in order to avoid "spot errors" or "pits", resulting in uneven deposit of phosphors or scintillators, due to spitting of the liquefied raw materials present in the heated container(s) as has been established hereinbefore for the continuous process. Measures taken therefore have been illustrated in Fig. 1 and, more in detail in Fig. 1B, more particularly with lamps used as baffles, and more preferably with three chimney heating elements, mounted versus the slot outlet (3') and positioned so that there is no direct path for vaporised particles from said raw materials to escape through said slot outlet (3').

In the vapour depositing apparatus used for performing the method according to the present invention vapour deposition of said phosphor or scintillator compositions is initiated by a vapour flow of raw materials from one or more crucible(s), wherein said vapour flow is generated by adding energy to said raw materials and said container(s), by thermal, electric, or electromagnetic energy or a combination thereof. So vapour depositing said phosphor or scintillator compositions advantageously proceeds by physical vapour deposition, by chemical vapour deposition or a by combination of physical and chemical vapour deposition.

With respect to the coated phosphor to be obtained in the vapour depositing apparatus used in the method according to the present invention said phosphor, in one embodiment, is a photostimulable phosphor. As has already been established hereinbefore a very interesting photostimulable (storage) phosphor that is successfully deposited in the vapour depositing apparatus of the present invention is a CsBr:Eu phosphor. Raw materials used in the preparation of CsBr:Eu storage phosphor plates or panels are CsBr and between 10⁻³ and 5 mol % of a Europium compound selected from the group consisting of EuX'₂, EuX'₃ and EuOX', X' being a halide selected from the group consisting of F, Cl, Br and I as has been used in the preparation method disclosed in PCT-filing WO 01/03156. Even more preferred is a binderless coating of the selected CsBr:Eu phosphor from CsBr and EuOBr raw materials, wherein the said phosphor is characterised by its particular needle-shaped form. The highly crystalline degree is easily analysed by X-ray diffraction (XRD) techniques, providing a particular XRD-spectrum as has been illustrated in US-Application 2001/0007352. Therefore a mixture of CsBr and EuOBr is provided as a raw material mixture in the crucibles, wherein a ratio between both raw materials normally is about 90% by weight of the cheap CsBr and 10% of the expensive EuOBr, both expressed as weight %. It has however been shown that as a function of coating (evaporating) temperature ratios can be adapted in favour of lower material and production cost, without resulting in changes in composition: so higher vaporisation temperatures for the raw material mixture in ratio amounts of 99.5 wt % of CsBr and 0.5 wt % of EuOBr provide the same result as before.

The preferred CsBr:Eu phosphor, obtained after vapour deposition as a needle-shaped phosphor in the vapour depositing apparatus used in the method according to the present invention, is characterized by voids between the needles. In order to fill those voids, measures can be taken as described in US-Application 2003/0168611, wherein voids are partially filled with a polymeric compound; as in US-Application 2003/0183777, wherein vapour deposited pigments like the preferred β-Cu-phthalocyanine nanocrystalline dye compound are filling said voids or as in US-Application 2004/0228963, wherein the voids are at least partially filled with polymeric compounds selected from the group consisting of silazane and siloxazane type polymeric compounds, mixtures thereof and mixtures of said silazane or siloxazane type polymeric compounds with compatible polymeric compounds. More particularly with respect to the said dyes or pigments, vapour deposition thereof can be performed in the vacuum deposition chamber used in the method according to the present invention.

In order to prepare sheets or panel provided with the preferred CsBr:Eu phosphor, the vapour depositing apparatus used in the method according to the present invention starts with mixed raw materials in the crucible(s) comprising, as phosphor precusors, at least wherein CsₓEu_{y}X'_{(x+αy)} is an activator precursor material, wherein x, y and α are integers, wherein x/y is more than 0.25 and wherein α is at least 2 and wherein X' represents Cl, Br, I or a combination thereof CsₓEu_{y}X'_{(x+αy)}, wherein the ratio of x to y exceeds a value of 0.25, wherein α ≥ 2 and wherein X' is a halide selected from the group consisting of Cl, Br and I and combinations.

In another embodiment said mixture of raw materials comprises, as phosphor precusors, at least CsBr and CsₓEu_{y}X'_{(x+αy)}, wherein the ratio of x to y exceeds a value of 0.25, wherein α ≥ 2 and wherein X' is a halide selected from the group consisting of Cl, Br and I and combinations thereof. Methods for preparing and coating desired CsBr:Eu phosphors, wherein use is made of precursors as set forth, have been described in US-Applications 2005/0184250 and 2005/0186329 respectively.

At the moment of deposition, a preferred stimulable phosphor or scintillator layer, prepared in the vapour depositing apparatus used for performing the method according to the present invention, is a binderless layer. This can be well understood, as at those high temperatures, presence of additional binders besides phosphors or scintillators raw materials in the container(s) would not be practical. It is however not excluded to make use of polymers or dyes, showing ability to become vaporised, e.g. by sublimation, in order to serve as binder material or coloring material, present in a layer e.g. between substrate and phosphor or scintillator layer or even as a filler, filling gaps - in part or integrally - appearing in form of voids or cracks between the preferred phosphor or scintillator needles in the coated layer. Moreover when laminating a polymer layer onto the deposited layer, it is not excluded that polymer material is filling, at least in part, the voids between those needles. Furtheron it is not excluded to provide the phosphor or scintillator sheets or panels, before or after cutting in desired formats, with a moisture-resistant layer, in order to protect the moisture-sensitive phosphor layer against deterioration. Particularly preferred layers are e.g. parylene (p-xylylene) layers as described in US-A 6,710,356, whether or not overcoated with a transparent organic layer of silazane or siloxazane type polymeric compounds or mixtures thereof as described in US-Application 2004/0164251. In the method of applying a protecting parylene layer to phosphor or scintillator coatings as a "parylene layer" a halogen-containing layer was preferred. More preferably said "parylene layer" is selected from the group consisting of a parylene D, a parylene C and a parylene HT layer. In the particular case a cross-linked polymeric layer is advantageously formed on a phosphor screen material, wherein the said polymeric material layer has been formed by reaction of at least one component, thereby forming self-condensing polymers. Reactive monomers are provided in form of heated vapour in order to form the desired condensation polymer on the substrate, wherein said condensation polymer is in form of a p-xylylene or "parylene" layer on the phosphor screen substrate. Examples of these "parylene" layers are poly-p-xylylene (Parylene-N), poly-monochloro-p-xylylene (Parylene-C) and polydichloro-p-xylylene (Parylene-D). If desired a pigment can be integrated into a thin film of a poly-p-xylylene as has been described in JP-A 62-135520.

Apart from a photostimulable phosphor layer, a prompt emitting luminescent phosphor can be coated in the vapour depositing apparatus used in the method according to the present invention. Such a luminescent phosphor is suitable for use e.g. in intensifying screens as used in screen/film radiography.

With respect to the specific applications, related with CR and DR, it is clear that in view of image quality, and more particularly in view of sharpness, binderless phosphor or scintillator layers as described hereinbefore are preferred. With respect thereto it is clear that vaporisation of raw materials in the vapour depositing apparatus used for performing the method according to the present invention, in order to build the desired scintillator or phosphor layers is a preferred technique, provided that, according to the method of the present invention the layers have been deposited on a flexible substrate, wherein it is envisaged to deform the flexible support in order to get a flat sheet or panel, ready-for-use, suited for specific CR and DR applications. Other hygroscopic phosphor or scintillator layers besides the preferred CsBr:Eu phosphor that are advantageously prepared according to the method of the present invention are e.g. BaFCl:Eu, BaFBr:Eu and GdOBr:Tm, used in intensifying screens; CsI:Na applied in scintillator panels and storage phosphors suitable for use in computed radiography (CR) as e.g. BaFBr:Eu, BaFI:Eu, (Ba,Sr)F(Br,I):Eu, RbBr:Tl, CsBr:Eu, CsCl:Eu and RbBr:Eu; or CsI:Tl, Lu₂O₂S:xM and Lu₂O₅Si:xM, wherein M is selected from the group of rare earth elements consisting of Eu, Pr and Sm and wherein x is from 0.0001 to 0.2, which is particularly suitable for use in DR-cassettes as disclosed in US-Applications 2004/0262536 and 2005/0002490 respectively.

### Examples

While the present invention will hereinafter be described in connection with preferred embodiments thereof, it will be understood that it is not intended to limit the invention to those embodiments.

A CsBr:Eu photostimulable phosphor screen having a flexible anodised aluminum was prepared in a vacuum chamber by means of a thermal vapour deposition process, starting from a mixture of CsBr and EuOBr as raw materials. Said deposition process onto said flexible anodized aluminum support was performed in such a way that said support was rotating so that the momentary magnitude of the velocity was constant over its whole area. An electrically heated oven and a refractory tray or boat in which 5000 - 6000 g of a mixture (4) of CsBr and EuOBr as raw materials in a 99.5%/0.5% CsBr/EuOBr percentage ratio by weight were present to become vaporised.

Crucible (4) was an elongated boat having a length of 100 cm, a width of 40 mm and a height of 80 mm, composed of "tantalum" having a thickness of 0.5 mm, composed of 3 integrated parts: a crucible container (4), an internally heated chimney (2) and a chimney inlet (3) and a controllable slot outlet (3').

The longitudinal parts are folded from one continuous tantalum base plate in order to overcome leakage and the head parts are welded. The chimney was provided with 3 lineair infrared heaters (quartz lamps) with a diameter of 11 mm (1) in order to heat the chimney in order to overcome condensation of vaporised materials. Moreover the chimney heaters (1) were positioned in a baffled way in order to overcome spatter of molten or vaporised material onto the substrate into an uncontrolled and unlimited way. A lip opening of 5 mm as controllable outlet (3') was used. A heat shield with slit opening was further shielding heat in order to avoid escape of heat and loss of energy, required to provoke vapour escape and deposit onto the continuously moving substrate support in a controlled and uniform way.

Under vacuum pressure (a pressure of 2 x 10⁻¹ Pa equivalent with 2 x 10⁻³ mbar) maintained by a continuous inlet of argon gas into the vacuum chamber, and at a sufficiently high temperature of the vapour source (760°C) and the chimney the obtained vapour was directed towards the moving sheet support and was deposited thereupon successively while said support was rotating over the vapour stream. Said temperature of the vapour source was measured by means of thermocouples present outside and pressed under the bottom of said crucible and tantalum protected thermocouples present in the crucible and in the chimney.

The anodised aluminum substrate support having a thickness of 280 µm, a width of 60 cm and a length of 250 cm was positioned at the side whereupon the phosphor should be deposited.

In the Table 1 chimney temperatures, crucible temperatures and real substrate temperatures have been set out, as well as the deposited phosphor amount and the relative speed (SAL%), which is defined as the speed of each of the screens compared with the reference speed of an MD10^{®} reference photostimulable phosphor screen manufactured by Agfa-Gevaert, Mortsel, Belgium.

**Table 1**

| Exp. No. | Chimney temp. T2 (°C) | Real substrate temp. | Crucible temp. T1 (°C) | Coating amount (mg/cm2) | SAL % |
|---|---|---|---|---|---|
| CB1280791 | 800-850 | 200 | 720 | 160.00 | 464 |
| CB1290183 | 800-850 | 200 | 720 | | 543 |
| CB1170112 | 600 | 200 | 750 | 137.60 | 355 |
| CB1170312 | 620 | 180 | 750 | 145.00 | 345 |

As becomes clear from the results in Table 1 an increased chimney temperature with at least 80°C provides a screen with a higher speed, corresponding with the object of the present invention.

Having described in detail preferred embodiments of the current invention, it will now be apparent to those skilled in the art that numerous modifications can be made therein without departing from the scope of the invention as defined in the appending claims.

### PARTS LIST

(1) chimney heaters
(2) internally heated chimney
(3) chimney outlet and (3') chimney slot outlet
(4) crucible, tray or boat.

## Claims

1. Method of preparing a storage phosphor layer on a support by vapour deposition from a crucible unit by heating as phosphor precursor raw materials a matrix component and an activator component or a precursor component thereof, wherein said crucible unit comprises at least a bottom and surrounding side walls as a crucible for phosphor precursor raw materials present in said crucible in liquid form, wherein said crucible unit further comprises at least a chimney as part of the crucible unit and a slit allowing phosphor precursor raw materials to escape in vaporised form from said crucible unit in order to deposit it as a phosphor layer onto said support, wherein the step of heating said precursor raw materials in the crucible in liquid form proceeds up to a temperature T1 and wherein the step of heating said precursor raw materials in vaporised form in said chimney, proceeds up to a temperature T2, **characterised in that** a positive difference in temperature [T2 - T1] is maintained.

2. Method according to claim 1, wherein said temperatures T1 and T2 are attained by radiation heating, resistive heating or a combination of radiation heating and resistive heating.

3. Method according to claim 1 or 2, wherein said temperatures are controlled by means of thermo-couples.

4. Method according to claim 1 or 2, wherein said temperatures are controlled and steered by means of thermo-couples.

5. Method according to claim 4, wherein said temperatures are steered by means of thermo-couples via a back-coupling mechanism.

6. Method according to any one of the claims 1 to 5, wherein a set of coupled thermo-couples is mounted in the raw materials, covering part of the bottom of the said crucible.

7. Method according to any one of the claims 1 to 6, wherein a set of coupled thermo-couples is present at the outside of the crucible, in contact with the bottom of said crucible in order to measure and steer temperature T1.

8. Method according to any one of the claims 1 to 7, wherein a set of coupled thermo-couples is present in the vaporised raw materials in the said chimney in order to measure and steer temperature T2.

9. Method according to any one of the claims 1 to 8, wherein CsX is a matrix component and EuX₂, EuX₃, EuOX or a mixture thereof are activator components, X representing C1, Br, I or a combination thereof.

10. Method according to any one of the claims 1 to 8, wherein CsₓEu_{y}X' (x+αy) is an activator precursor material, wherein x, y and α are integers, wherein x/y is more than 0.25 and wherein α is at least 2 and wherein X' represents C1, Br, I or a combination thereof.

11. Method according to any one of the claims 1 to 10, wherein said
storage phosphor is CsBr:Eu.

12. method according to any one of the claims 1 to 11, wherein temperature T1 is higher than 640°C.

13. Method according to any one of the claims 1 to 11, wherein temperature T2 is higher than 640°C.

14. Method according to any one of the claims 1 to 11, wherein a difference in temperature [T2 - T1] of at least 80°C is maintained.

15. Method according to any one of the claims 1 to 14, wherein said vapour deposition proceeds in a batch or in a continuous process.■

## Patentansprüche

1. Ein Verfahren zur Herstellung einer Speicherleuchtstoffschicht auf einem Träger durch Aufdampfung aus einer Tiegeleinheit, wobei als Rohmaterialen einer Leuchtstoffvorstufe eine Matrixkomponente und eine Aktivatorkomponente oder eine Vorstufekomponente derselben erhitzt werden, wobei die Tiegeleinheit mindestens einen Boden und umgebende Seitenwände als Tiegel für in Flüssigform im Tiegel enthaltene Rohmaterialen einer Leuchtstoffvorstufe umfasst, wobei die Tiegeleinheit ferner mindestens eine Ausblasleitung als Teil der Tiegeleinheit und einen Schlitz, der die Rohmaterialien der Leuchtstoffvorstufe in verdampfter Form aus der Tiegeleinheit ausströmen und sich als Leuchtstoffschicht auf den Träger abscheiden lässt, umfasst, wobei der Schritt der Erhitzung der flüssigen Rohmaterialien der Vorstufe im Tiegel bis auf eine Temperatur T1 läuft und der Schritt der Erhitzung der dampfförmigen Rohmaterialien der Vorstufe in der Ausblasleitung bis auf eine Temperatur T2 läuft, **dadurch gekennzeichnet, dass** ein positiver Temperaturunterschied [T2 - T1] erhalten wird.

2. Verfahren nach Anspruch 1, **dadurch gekennzeichnet, dass** die Temperaturen T1 und T2 durch Strahlungserhitzung, Widerstandserhitzung oder eine Kombination einer Strahlungserhitzung und einer Widerstandserhitzung erhalten wird.

3. Verfahren nach Anspruch 1 oder 2, **dadurch gekennzeichnet, dass** die Temperaturen durch Thermoelemente kontrolliert werden.

4. Verfahren nach Anspruch 1 oder 2, **dadurch gekennzeichnet, dass** die Temperaturen durch Thermoelemente kontrolliert und gesteuert werden.

5. Verfahren nach Anspruch 4, **dadurch gekennzeichnet, dass** die Temperaturen über einen Rückkopplungsmechanismus durch Thermoelemente gesteuert werden.

6. Verfahren nach einem der Ansprüche 1 bis 5, **dadurch gekennzeichnet, dass** in den Rohmaterialien ein Satz miteinander gekoppelter Thermoelemente, die einen Teil des Bodens des Tiegels bedecken, angeordnet ist.

7. Verfahren nach einem der Ansprüche 1 bis 6, **dadurch gekennzeichnet, dass** an der Außenseite des Tiegels, im Berührung mit dem Boden des Tiegels, ein Satz miteinander gekoppelter Thermoelemente angeordnet ist, um die Temperatur T1 zu messen und zu steuern.

8. Verfahren nach einem der Ansprüche 1 bis 7, **dadurch gekennzeichnet, dass** in den dampfförmigen Rohmaterialien in der Ausblasleitung ein Satz miteinander gekoppelter Thermoelemente angeordnet ist, um die Temperatur T2 zu messen und zu steuern.

9. Verfahren nach einem der Ansprüche 1 bis 8, **dadurch gekennzeichnet, dass** CsX eine Matrixkomponente und EuX₂, EuX₃, EuOX oder ein Gemisch derselben Aktivatorkomponenten sind, wobei X Cl, Br, I oder eine Kombination derselben bedeutet.

10. Verfahren nach einem der Ansprüche 1 bis 8, **dadurch**
**gekennzeichnet, dass** CsₓEu_{y}X' (_{x+αy}) ein Aktivatorvorstufenmaterial ist, wobei x, y und α ganze Zahlen sind, wobei x/y mehr als 0,25 beträgt und wobei α mindestens 2 beträgt und wobei X' Cl, Br, I oder eine Kombination derselben bedeutet.

11. Verfahren nach einem der Ansprüche 1 bis 10, **dadurch**
**gekennzeichnet, dass** der Speicherleuchtstoff CsBr:Eu ist.

12. Verfahren nach einem der Ansprüche 1 bis 11, **dadurch**
**gekennzeichnet, dass** die Temperatur T1 bei mehr als 640°C liegt.

13. Verfahren nach einem der Ansprüche 1 bis 11, **dadurch**
**gekennzeichnet, dass** die Temperatur T2 bei mehr als 640°C liegt.

14. Verfahren nach einem der Ansprüche 1 bis 11, **dadurch**
**gekennzeichnet, dass** ein Temperaturunterschied [T2 - T1] von mindestens 80°C erhalten wird.

15. Verfahren nach einem der Ansprüche 1 bis 14, **dadurch**
**gekennzeichnet, dass** die Aufdampfung batchweise oder kontinuierlich erfolgt.

## Revendications

1. Un procédé pour la fabrication d'une couche de luminophore à mémoire sur un support par dépôt en phase gazeuse à partir d'une unité de creuset, ledit procédé consistant à chauffer comme matériaux de base d'un précurseur de luminophore un composant de matrice et un composant activateur ou un composant précurseur de celui-ci, ladite unité de creuset comprenant au moins un sol et des parois latérales entourantes comme creuset pour les matériaux de base d'un précurseur de luminophore contenus sous forme liquide dans le creuset, ladite unité de creuset comprenant en outre au moins une conduite d'évacuation faisant partie de l'unité de creuset, ainsi qu'une fente permettant aux matériaux de base du précurseur de luminophore sous forme vaporisée de quitter l'unité de creuset pour se déposer ensuite comme couche de luminophore sur le support, où l'étape du chauffage des matériaux de base du précurseur contenus sous forme liquide dans le creuset se poursuit jusqu'à obtention d'une température T1 et où l'étape du chauffage des matériaux de base du précurseur contenus sous forme vaporisée dans la conduite d'évacuation se poursuit jusqu'à obtention d'une température T2, **caractérisé en ce qu'**une différence de température positive [T2 - T1] est maintenue.

2. Procédé selon la revendication 1, **caractérisé en ce que** les températures T1 et T2 sont obtenues par chauffage par irradiation, par chauffage par résistance ou par une combinaison d'un chauffage par irradiation et d'un chauffage par résistance.

3. Procédé selon la revendication 1 ou 2, **caractérisé en ce que** les températures sont contrôlées par des thermocouples.

4. Procédé selon la revendication 1 ou 2, **caractérisé en ce que** les températures sont contrôlées et réglées par des thermocouples.

5. Procédé selon la revendication 4, **caractérisé en ce que** les températures sont réglées par des thermocouples par le biais d'un mécanisme de rétroaction.

6. Procédé selon l'une quelconque des revendications 1 à 5, **caractérisé en ce qu'**un ensemble de thermocouples raccordés entre eux est disposé dans les matériaux de base et recouvre une partie du sol du creuset.

7. Procédé selon l'une quelconque des revendications 1 à 6, **caractérisé en ce qu'**un ensemble de thermocouples raccordés entre eux est disposé à la partie extérieure du creuset, en contact avec le sol du creuset, afin de mesurer et de régler la température T1.

8. Procédé selon l'une quelconque des revendications 1 à 7, **caractérisé en ce qu'**un ensemble de thermocouples raccordés entre eux est disposé dans les matériaux de base contenus sous forme vaporisée dans la conduite d'évacuation, afin de mesurer et de régler la température T2.

9. Procédé selon l'une quelconque des revendications 1 à 8, **caractérisé en ce que** CsX est un composant de matrice et que EuX₂, EuX₃, EuOX ou un mélange de ceux-ci sont des composants activateurs, X étant C1, Br, I ou une combinaison de ceux-ci.

10. Procédé selon l'une quelconque des revendications 1 à 8, **caractérisé en ce que** CsₓEu_{y}X'(_{x+αy}) représente un matériau de précurseur activateur, où x, y et α sont des nombres entiers, où x/y est supérieur à 0,25 et où α s'élève à au moins 2 et où X' représente Cl, Br, I ou une combinaison de ceux-ci.

11. Procédé selon l'une quelconque des revendications 1 à 10,
**caractérisé en ce que** le luminophore à mémoire est le CsBr:Eu.

12. Procédé selon l'une quelconque des revendications 1 à 11,
**caractérisé en ce que** la température T1 est supérieure à 640°C.

13. procédé selon l'une quelconque des revendications 1 à 11,
**caractérisé en ce que** la température T2 est supérieure à 640°C.

14. Procédé selon l'une quelconque des revendications 1 à 11,
**caractérisé en ce qu'**une différence de température [T2 - T1] minimale de 80°C est maintenue.

15. Procédé selon l'une quelconque des revendications 1 à 14,
**caractérisé en ce que** le dépôt en phase gazeuse s'effectue par lots ou de façon continue.
